# EUROPÄISCHE PATENTSCHRIFT

(11) **EP 3 043 537 B1**
(45) Veröffentlichungstag und Bekanntmachung des Hinweises auf die Patenterteilung: **13.03.2019**
(21) Anmeldenummer: 16150361.0
(22) Anmeldetag: 07.01.2016
(51) Int. Cl.: H04M 1/11, H04W 24/08, H04W 88/06, H04M 1/02, H01Q 1/52

(54) **GEHÄUSE FÜR EIN MOBILTELEFON ZUR DÄMPFUNG VON FUNKSIGNALEN**
HOUSING OF A MOBILE TELEPHONE FOR ABSORBING OF RADIO SIGNALS
BOITIER D' UN TELEPHONE PORTABLE POUR L'ATTÉNUATION DE SIGNAL RADIOÉLECTRIQUE

(30) Priorität: 12.01.2015 DE 102015000062; 14.01.2015 DE 102015100519
(43) Veröffentlichungstag der Anmeldung: 13.07.2016
(73) Patentinhaber: P3 Communications GmbH, 52070 Aachen (DE)
(72) Erfinder: REIFFENRATH, Jan Matti, 52072 Aachen (DE); SEIDENBERG, Peter, 52072 Aachen (DE)
(74) Vertreter: Michalski Hüttermann & Partner Patentanwälte mbB

(56) Entgegenhaltungen:
- EP-A1- 0 915 572
- WO-A1-00/13330
- WO-A2-2012/033762
- US-A1- 2009 146 862
- US-A1- 2009 248 500
- US-A1- 2011 011 760
- US-A1- 2012 055 824
- US-A1- 2012 118 769
- Eccosorb: "ECCOSORB LS Description", , 30. April 2011 (2011-04-30), XP055277734, Gefunden im Internet: URL:http://www.electronic-service.de/files /eb_040_eccosorb_ls.pdf [gefunden am 2016-06-03]

## Beschreibung

Die Erfindung betrifft ein Gehäuse mit einer Gehäusewand, wobei in dem Gehäuse ein von der Gehäusewand ausgebildeter und umgebender Innenraum ausgebildet ist, in den ein Mobiltelefon einsetzbar ist. Zudem betrifft die Erfindung ein Verfahren zum Herstellen des Gehäuses für das Mobiltelefon sowie ein Verfahren zum Dämpfen eines Mobilfunksignals des Mobiltelefons.

Zur Qualitätssicherung und Optimierung von Mobilfunknetzen ist es aus dem Stand der Technik bekannt, von einem Mobiltelefon wiederholt Sprach- und Datenverbindungen zu unterschiedlichen Zielen aufzubauen, um dann, beispielsweise anhand der gemessenen Gesprächsaufbauzeit oder Geschwindigkeit einer Internetverbindung, Rückschlüsse auf die Qualität des benutzen Mobilfunknetzes zu ziehen. Um die Messungen möglichst realitätsnah zu gestalten, werden für Endverbraucher erwerbbare Mobiltelefone eingesetzt. Bei einem sogenannten "drive test", bei dem entlang einer vorgegebenen Fahrtroute wiederholte Messungen durchgeführt werden, sind die Mobiltelefone innerhalb eines Messfahrzeugs angeordnet, wobei jedoch, um möglichst vergleichbare Bedingungen für unterschiedliche Netzbetreiber zu schaffen, die Mobiltelefone mit externen, außerhalb des Messfahrzeugs angeordneten Antennen versehen sind. Derartige Antennen sind beispielsweise in einer Dachbox des Messfahrzeugs installiert und mittels eines Koaxialkabels mit dem Mobiltelefon verbunden.

Derzeitig angebotene Mobiltelefone verfügen jedoch immer seltener über einen externen Antennenanschluss zur Konnektierung des Koaxialkabels, so dass das Koaxialkabel in händischer Weise mit dem Mobiltelefon verbunden werden muss, so vielfach durch Verlöten. Darüber hinaus weisen derzeitig angebotene Mobiltelefone oftmals unterschiedliche interne Antennen für unterschiedliche Mobilfunkstandards auf, was einerseits die Verbindung äußerst aufwendig macht und andererseits zur möglichst exakten Nachbildung des Sende-/Empfangsverhalten der internen Antennen eine Vielzahl externer Antennen voraussetzt. Da die derzeit verwendeten Mobilfunkstandards unterschiedliche Frequenzen verwenden, beispielsweise 806 MHz bei LTE800 bis hin zu 2630 MHz bei LTE2600, ergeben sich darüber hinaus aufgrund der Frequenzabhängigkeit der Koaxialkabel unterschiedliche Dämpfungen, die, einschließlich einer konstanten Dämpfung von 6 dB zur Simulation beispielsweise von im Gebäudeinneren geführten Telefonaten, bei vorgenannten Frequenzen im Bereich von 9,7 dB bis hin zu 14,5 dB variieren, was nicht selten zu einer Verfälschung der Messergebnisse führt.

Ausgehend davon ist eine Aufgabe der Erfindung, eine Möglichkeit anzugeben, wie in besonders einfacher Weise eine definierte und möglichst gleichbleibende Dämpfung eines Mobilfunksignals, insbesondere einer von einem Mobiltelefon erzeugten und/oder empfangenen elektromagnetische Strahlung, erreicht werden kann.

Die Aufgabe der Erfindung wird durch die Merkmale der unabhängigen Ansprüche gelöst. Bevorzugte Weiterbildungen sind in den Unteransprüchen angegeben.

Demnach erfolgt die Lösung der Aufgabe durch ein Gehäuse mit einer Gehäusewand, umfassend ein elektrisch leitfähige Partikel umfassendes Polymer, wobei in dem Gehäuse ein von der Gehäusewand ausgebildeter und umgebender Innenraum vorgesehen ist, in den ein Mobiltelefon einsetzbar ist, und die Gehäusewand ausgeführt ist, ein Mobilfunksignal des Mobiltelefons auf der dem Innenraum abgewandten Seite der Gehäusewand gegenüber einer ungehinderten Ausbreitung um ≥ 3 dB zu dämpfen.

Ein wesentlicher Punkt der Erfindung ist damit, dass das in das Gehäuse eingesetzte Mobiltelefon von der Gehäusewand umgeben ist. Durch die als elektrisch leitfähige Partikel umfassendes Polymer ausgestaltete Gehäusewand wird die Dämpfung des Mobilfunksignals bewirkt. Die Dämpfung ist weitgehend unabhängig von der Frequenz, so dass bei unterschiedlichen Mobilfunkstandards mit unterschiedlichen Frequenzen jeweils eine sehr ähnliche oder sogar die gleiche Dämpfung erzielt wird. Somit lässt sich auf besonders einfache Weise eine gleichbleibende Dämpfung erzielen, was in der Folge zu qualitativ hochwertigeren und bei unterschiedlichen Frequenzen unmittelbar miteinander vergleichbaren Messergebnissen führt.

Die der Innenwand abgewandte Seite der Gehäusewand meint einen Ort außerhalb des Gehäuses, beispielsweise 10 cm, 50 cm oder 1 m von dem Mobiltelefon entfernt. Die ungehinderte Ausbreitung meint einen Ort in quasi direkter Sichtweite des Mobiltelefons, der beispielsweise ebenso 10 cm, 50 cm respektive 1 m von dem Mobiltelefon entfernt 6 dB zur Simulation beispielsweise von im Gebäudeinneren geführten Telefonaten, bei vorgenannten Frequenzen im Bereich von 9,7 dB bis hin zu 14,5 dB variieren, was nicht selten zu einer Verfälschung der Messergebnisse führt.

US 2011/011760 A1 beschreibt ein Kit zum Aufnahmen, zum Isolierung und zum Transport von Computerhardware mit einem Gehäuse, wobei das Gehäuse eine Auskleidung aufweist, um den Inhalt des Kits während des Transports von RF-Signalen zu isolieren.

WO 0013330 A1 beschreibt ein Mobiltelefon Traggehäuse, welches ein Mobiltelefon umhüllen und dadurch schützen kann.

Ausgehend davon ist eine Aufgabe der Erfindung, eine Möglichkeit anzugeben, wie in besonders einfacher Weise eine definierte und möglichst gleichbleibende Dämpfung eines Mobilfunksignals, insbesondere einer von einem Mobiltelefon erzeugten und/oder empfangenen elektromagnetische Strahlung, erreicht werden kann.

Die Aufgabe der Erfindung wird durch die Merkmale der unabhängigen Ansprüche gelöst. Bevorzugte Weiterbildungen sind in den Unteransprüchen angegeben.

Demnach erfolgt die Lösung der Aufgabe durch ein Gehäuse mit einer Gehäusewand, umfassend ein elektrisch leitfähige Partikel umfassendes Polymer, wobei in dem Gehäuse ein von der Gehäusewand ausgebildeter und umgebender Innenraum vorgesehen ist, in den ein Mobiltelefon einsetzbar ist, und die Gehäusewand ausgeführt ist, ein Mobilfunksignal des Mobiltelefons auf der dem Innenraum abgewandten Seite der Gehäusewand gegenüber einer ungehinderten Ausbreitung um ≥ 3 dB zu dämpfen.

Ein wesentlicher Punkt der Erfindung ist damit, dass das in das Gehäuse eingesetzte Mobiltelefon von der Gehäusewand umgeben ist. Durch die als elektrisch leitfähige Partikel umfassendes Polymer ausgestaltete Gehäusewand wird die Dämpfung des Mobilfunksignals bewirkt. Die Dämpfung ist weitgehend unabhängig von der Frequenz, so dass bei unterschiedlichen Mobilfunkstandards mit unterschiedlichen Frequenzen jeweils eine sehr ähnliche oder sogar die gleiche Dämpfung erzielt wird. Somit lässt sich auf besonders einfache Weise eine gleichbleibende Dämpfung erzielen, was in der Folge zu qualitativ hochwertigeren und bei unterschiedlichen Frequenzen unmittelbar miteinander vergleichbaren Messergebnissen führt.

Die der Innenwand abgewandte Seite der Gehäusewand meint einen Ort außerhalb des Gehäuses, beispielsweise 10 cm, 50 cm oder 1 m von dem Mobiltelefon entfernt. Die ungehinderte Ausbreitung meint einen Ort in quasi direkter Sichtweite des Mobiltelefons, der beispielsweise ebenso 10 cm, 50 cm respektive 1 m von dem Mobiltelefon entfernt ist, wobei das Mobiltelefon nicht in dem Gehäuse angeordnet ist. Bei in dem Gehäuse eingesetztem Mobiltelefon ist das Mobiltelefon vorzugsweise vollständig von der Gehäusewand umgeben, wobei es jedoch auch möglich sein kann, dass der Innenraum eine Öffnung aufweist, also das Mobiltelefon nur teilweise umgibt. Das Mobilfunksignal meint insbesondere eine von dem Mobiltelefon erzeugte und/oder empfangene elektromagnetische Strahlung, die beispielsweise bei einer Sprach- und/oder Datenverbindung nach dem Mobilfunkstandard LTE800, GSM900, GSM1800, LTE1800, UMTS2100 oder LTE2600 zwischen dem Mobiltelefon und einer Basisstation eines Netzbetreibers entsteht.

Nach einer bevorzugten Ausgestaltung ist die Gehäusewand ausgeführt, das Mobilfunksignal, insbesondere eine von dem Mobiltelefon erzeugte und/oder empfangene elektromagnetische Strahlung, um ≥ 5 dB und ≤ 15 dB, vorzugsweise um ≥ 7 dB und ≤ 13 dB, ganz besonders bevorzugt um 12 dB zu dämpfen. Darüber hinaus sind weitere Bereiche denkbar, die aus der Gruppe ≥ 3 dB, ≥ 4 dB, ≥ 5 dB, ≥ 6 dB, ≥ 7 dB, ≥ 8 dB, ≥ 9 dB oder ≥ 10 dB respektive ≤ 10 dB, ≤ 11 dB, ≤ 12 dB, ≤ 13 dB, ≤ 14 dB, ≤ 15 dB, ≤ 20 dB, ≤ 30 dB, ≤ 40 dB oder ≤ 50 dB gebildet sind. Eine Ausgestaltung mit geringerer Dämpfung ist vorteilig bei einer Messung innerhalb eines Gebäudes, während eine größere Dämpfung vorteilig bei einer Messung in einem Messfahrzeug im Rahmen eines sogenannten "drive tests" ist. Bei der letztgenannten Messung erfolgt die Anordnung des Gehäuses bevorzugt an einer Seitenscheibe oder in einer Dachbox des Messfahrzeugs.

Grundsätzlich existieren zur Ausgestaltung des Gehäuses verschiedene Möglichkeiten. Beispielsweise kann das Gehäuse die Form eines Würfels oder kugelförmig ausgestaltet sein. Nach einer besonders bevorzugten Ausgestaltung weist die Gehäusewand einen Gehäuseboden und vorzugsweise vier Gehäuseseitenwände derart auf, dass der Innenraum in vorzugsweise quaderartiger Form oder als Quader ausgebildet ist. Die Gehäuseseitenwände sind bevorzugt spaltfrei mit dem Gehäuseboden verbunden und erstrecken sich rechtwinklig von diesem weg. Der quaderartige Innenraum kann unverschlossen sein, so dass das Mobiltelefon in besonders einfacher Weise durch die Öffnung in den Innenraum einsetzbar und wieder entnehmbar ist.

Nach einer besonders bevorzugten Ausführungsform weist die Gehäusewand einen Gehäusedeckel zum Bedecken des Innenraums auf, wobei vorzugsweise der Gehäusedeckel verschwenkbar oder klappbar an einer Gehäuseseitenwand gehalten ist. In der Schließstellung liegt der Gehäusedeckel bevorzugt auf wenigstens einer oder allen Gehäuseseitenwänden berührend auf, wobei es jedoch auch möglich ist, dass der Gehäusedeckel beabstandet zu der Gehäuseseitenwand zu liegen kommt. In einer alternativen Ausgestaltung ist der Gehäusedeckel mittels eines Klettverschlusses, eines Scharniers oder eines sonstigen aus dem Stand der Technik bekannten Befestigungsmittel an der Seitenwand befestigbar. Vorzugsweise weist der Gehäusedeckel eine gleich große flächige Erstreckung wie der Gehäuseboden auf.

Zur Formstabilisierung des Gehäusedeckels und/oder des Gehäusebodens können eine Deckelplatte bzw. eine Bodenplatte vorgesehen sein, welche vorteiligerweise aus einem Kunststoff mit einer Dicke von beispielweise 2 mm oder 4 mm ausgestaltet sind und an der dem Innenraum abwandten Seite mit dem Gehäusedeckel bzw. dem Gehäuseboden berührend verbunden sind, insbesondere verklebt sind. In weiter vorteilhafter Weise ist eine Seitenplatte vorgesehen, welche aus einem Kunststoff mit einer Dicke von beispielsweise 4 mm ausgestaltet ist und welche einerseits rechtwinklig in fixer Weise mit der Bodenplatte verbunden ist und andererseits in verschwenkbarer Weise mit der Deckelplatte verbunden ist. Die Gehäuseseitenwand ist bevorzugt berührend mit der Seitenplatte verbunden, insbesondere verklebt.

Nach einer bevorzugten Weiterbildung ist ein Gehäusezwischenelement aus dem elektrisch leitfähige Partikel umfassenden Polymer vorgesehen, welches in dem Gehäuse einen weiteren Innenraum ausbildet, in den ein weiteres Mobiltelefon einsetzbar ist. Vorzugsweise liegt das Gehäusezwischenelement berührend an dem Gehäuseboden und/oder an den Gehäuseseitenwänden an. Besonders bevorzugt sind eine Mehrzahl von Gehäusezwischenelementen vorgesehen, die zwei, vier, sechs oder acht Innenräume ausbilden, so dass entsprechend vier, sechs bzw. acht Mobiltelefone in dem Gehäuse aufnehmbar sind.

In weiter vorteiliger Weise werden die Mobiltelefone durch das zwischen ihnen befindliche Gehäusezwischenelement gegeneinander gedämpft und derart entkoppelt bzw. teilweise gegeneinander abgeschirmt, so dass sich eine kompakte Bauform des Gehäuses realisieren lässt. Bei den aus dem Stand der Technik bekannten Anordnungen müssen die Mobiltelefone in einem ausreichenden Abstand voneinander im Messfahrzeug positioniert werden, was insbesondere bei einer Vielzahl von Mobiltelefonen (≥ 4) in einem Messfahrzeug sehr schwierig ist: Denn für eine qualitativ hochwertige Messung müssen für jedes Mobiltelefon gegenüber der Außenwelt die gleichen Empfangsbedingungen geschafft werden und gleichzeitig ein Mindestabstand (von mehreren 10 cm) zwischen den Mobiltelefonen eingehalten werden.

Durch die vorgeschlagene Lösung können die Mobiltelefone jedoch mit einem Abstand von sehr wenigen cm voneinander positioniert werden, so dass bei gleichem Platzbedarf wesentlich mehr Mobiltelefone in einem Messfahrzeug verwenden werden können. Mit anderen Worten lassen sich in einem einzigen Gehäuse eine Mehrzahl Mobiltelefone betreiben, die jeweils eine möglichst gleiche oder sogar die gleiche Dämpfung ihres Mobilfunksignals erfahren. Somit lassen sich gleichzeitig unterschiedliche Mobilfunknetze messen, wobei die Messergebnisse aufgrund der jeweils gleichen oder annährend gleichen Dämpfung direkt miteinander vergleichbar sind.

Nach einer bevorzugten Weiterbildung ist ein an der Gehäusewand angeordnetes Telefonabstandselement vorgesehen, welches eingerichtet ist, bei in dem Innenraum eingesetztem Mobiltelefon, einen Luftspalt zwischen dem Mobiltelefon und der Gehäusewand auszubilden. Nach einer noch weiter bevorzugten Weiterbildung ist ein Deckelabstandelement vorgesehen, welches eingerichtet ist, bei mit dem Gehäusedeckel bedecktem Innenraum, einen Luftspalt wenigstens zwischen einer Gehäuseseitenwand und dem Gehäusedeckel auszubilden. Das Telefonabstandselement und/oder das Deckelabstandelement ist bevorzugt als in dem Innenraum auf den Gehäuseboden, auf dem Gehäusedeckel, auf den Gehäusewänden und/oder auf dem Gehäusezwischenelement vorgesehener Klebefuß ausgestaltet, beispielsweise als rechteckiger oder runder Klebefuß aus Kunststoff, wobei jedoch auch andere Mittel denkbar sind.

Zur Ausgestaltung der Gehäusewand mit dem das elektrisch leitfähige Partikel umfassende Polymer existieren grundsätzlich verschiedene Möglichkeiten. Besonders bevorzugt weist die Gehäusewand eine Imprägnierung mit einer Ruß-Dispersion auf, weist die Gehäusewand eine Kohlenstoffteilchen umfassende Schicht mit einem spezifischen Widerstand von ≥ 10⁻³ Ohm cm bis ≤ 10⁸ Ohm cm auf und/oder ist die Gehäusewand aus einem Polyurethanschaum ausgestaltet ist, der einen relativen Wellenwiderstand von ≥ 0,13 und ≤ 0,83, gemessen bei einer Frequenz von 3 GHz, aufweist. Die Imprägnierung mit der Ruß-Dispersion erfolgt bevorzugt derart, dass ein Polyurethanschaum mit einem Latex imprägniert wird, der Rußteilchen enthält, wodurch der Ruß bevorzugt nur auf der Oberfläche des Polyurethanschaums zu liegen kommt und der Latex nach dem Trocknen der Dispersion den Ruß als Bindemittel bindet.

Besonders bevorzugt ist die Gehäusewand aus dem unter dem Markennamen ECCOSORB LS vertriebenen Polyurethanschaum ausgestaltet, wobei besonders vorteilig ECCOSORB LS in der Spezifikation LS-26 verwendet wird. Entsprechend weist die Gehäusewand eine Dämpfung von bevorzugt 16 dB/cm und einen relativen Wellenwiderstand von ≥ 0,18, gemessen bei einer Frequenz von 3 GHz und mit dem Fachmann bekannten Messverfahren, auf. Anstelle von Kohlenstoffteilchen lassen sich auch Polymere mit Metallpartikeln und/oder Nanopartikel verwenden, wobei die Verwendung von Kohlenstoffteilchen, insbesondere von Ruß, wesentlich kostengünstiger ist. Der spezifische Widerstand lässt sich anhand der Norm ASTM D 257 bestimmen. Vorzugsweise liegt der Widerstand in einem Bereich von ≥ 10⁻² Ohm cm bis ≤ 10⁶ Ohm cm, weiter bevorzugt in einem Bereich von ≥ 10⁻¹ Ohm cm bis ≤ 10⁵ Ohm cm. Die zur Berechnung des spezifischen Widerstands benötigte Schichtdicke der Kohlenstoffteilchen umfassenden Schicht lässt sich aus elektronenmikroskopischen Querschnittsaufnahmen ermitteln.

Nach einer weiteren bevorzugten Ausführungsform weist das Gehäuse das Mobiltelefon und eine Mehrzahl von derart ausgebildeten Telefonabstandselementen auf, dass zwischen allen Gehäuseseitenwänden, dem Gehäuseboden und, bei mit dem Gehäusedeckel bedecktem Innenraum, dem Gehäusedeckel sowie dem Gehäusezwischenelement jeweils ein Luftspalt ausgebildet ist und das Mobiltelefon in dem Innenraum fixiert ist. Bevorzugt liegt dazu das Mobiltelefon berührend an den jeweiligen Telefonabstandselementen an, so dass bei einem Transport des Gehäuses das Mobiltelefon in einer durch die Telefonabstandselemente vordefinierten Position gehaltert ist. Das Mobiltelefon kann grundsätzlich als ein beliebiges Mobiltelefon ausgestaltet sein, so beispielsweise als ein Smartphone, welches in vorteiliger Weise Mobilfunksignale nach den Mobilfunkstandards GSM, UMTS und LTE aussendet und empfängt.

Die Aufgabe der Erfindung wird zudem durch ein Verfahren zum Herstellen eines Gehäuses für ein Mobiltelefon gelöst, mit den Schritten:
Bereitstellen einer Lage eines elektrisch leitfähige Partikel umfassenden flächigen Polymers als Gehäuseboden,
Verbinden von einer weiteren Lage des elektrisch leitfähige Partikel umfassenden flächigen Polymers als Gehäuseseitenwände mit dem Gehäuseboden derart, dass ein Innenraum in vorzugsweise quaderartiger Form ausgebildet wird, in den das Mobiltelefon einsetzbar ist, und
Bedecken des Innenraums mit einer noch weiteren Lage des elektrisch leitfähige Partikel umfassenden flächigen Polymers als Gehäusedeckel, wobei
der Gehäuseboden, die Gehäuseseitenwände und der Gehäusedeckel aus dem elektrisch leitfähige Partikel umfassenden Polymer derart ausgeführt sind, dass ein Mobilfunksignal des Mobiltelefons auf der dem Innenraum abgewandten Seite der Gehäusewand gegenüber einer ungehinderten Ausbreitung um ≥ 3 dB gedämpft wird.

Bevorzugt sind die Lagen des elektrisch leitfähige Partikel umfassenden flächigen Polymers aus dem unter Markennamen ECCOSORB LS vertriebenen Polyurethanschaum ausgestaltet, insbesondere nach der Spezifikation LS-26, durch welche eine Dämpfung von 16 dB/cm und ein relativer Wellenwiderstand Z/Z₀ von 0,18 bei einer Frequenz von 3 GHz bzw. 34 dB/cm und einem relativen Wellenwiderstand Z/Z₀ von 0,31 bei einer Frequenz von 10 GHz erreicht wird. Die Dicke der Lagen beträgt bevorzugt jeweils 0,25" bzw. 6,35 mm, wobei weiter bevorzugt zwei weitere berührend übereinander angeordnete Lagen zur Ausbildung der Gehäuseseitenwände verwendet werden. Besonders bevorzugt werden die einzelnen Lagen zur Ausbildung des Gehäusebodens, der Gehäuseseitenwände und des Gehäusedeckels aus einer Lage ECCOSORB LS ausgeschnitten.

Schließlich wird die Aufgabe der Erfindung durch ein Verfahren zum Dämpfen eines Mobilfunksignals eines Mobiltelefons gelöst, mit den Schritten:
Bereitstellen eines Gehäuses wie zuvor beschrieben,
Einsetzen des Mobiltelefons in den Innenraum, und
Bedecken des Innenraums mit dem Gehäusedeckel.

In vorteilhafter Weise wird durch das Verfahren eine weitgehend frequenzunabhängige Dämpfung des Mobilfunksignals des Mobiltelefons erreicht, so dass mit einem einzigen Mobiltelefon unterschiedliche Mobilfunkstandards mit jeweils unterschiedlen Frequenzen in direkt vergleichbarer Weise messbar sind oder mittels einer Mehrzahl von jeweils in einem Innenraum vorgesehenen Mobiltelefonen in direkt vergleichbarer Weise unterschiedliche Mobilfunknetze, gegebenenfalls auch mit unterschiedlichen Mobilfunkstandards mit jeweils unterschiedlen Frequenzen, gemessen werden können.

Weitere Ausführungsformen und Vorteile der zuvor genannten Verfahren ergeben sich für den Fachmann in Analogie zu dem zuvor beschriebenen Gehäuse.

Nachfolgend wird die Erfindung unter Bezugnahme auf die anliegende Zeichnung anhand einer bevorzugten Ausführungsform näher erläutert.

Es zeigen
- Fig. 1: ein Gehäuse nach einer bevorzugten Ausführungsform der Erfindung in einer Seitansicht,
- Fig. 2: das Gehäuse nach Fig. 1 in Draufsicht.

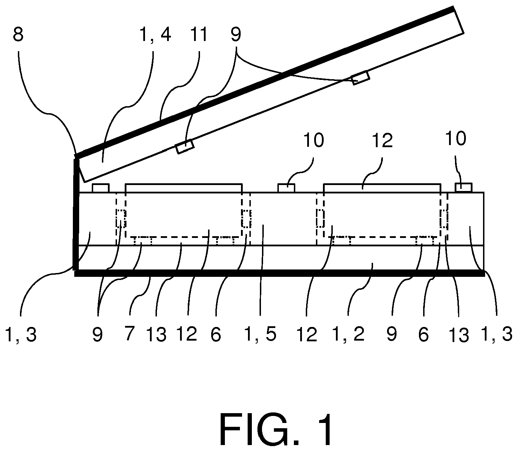

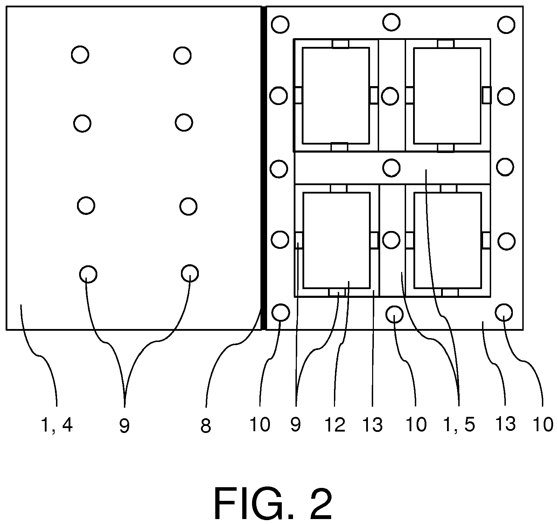

Fig. 1 zeigt ein Gehäuse nach einer bevorzugten Ausführungsform der Erfindung in einer Seitansicht. Das Gehäuse weist eine Gehäusewand 1 auf, welche einen Gehäuseboden 2, vier Gehäuseseitenwände 3 sowie einen Gehäusedeckel 4 umfasst. Die Gehäuseseitenwände 3 erstrecken sich berührend von dem Gehäuseboden 2 senkrecht weg und bilden zusammen mit drei Gehäusezwischenelementen 5, die sich ebenfalls berührend vom Gehäuseboden 2 senkrecht weg erstrecken, vier jeweils eine quaderartiger Form aufweisende Innenräume 6 aus, dargestellt in der Fig. 1 durch gestrichelte Linien. Durch den Gehäusedeckel 4 sind die vier Innenräume 6 abdeckbar, wobei der Gehäusedeckel 4 in Fig. 1 in einer teilweise geöffneten Position mit einem Öffnungswinkel von etwa 30° und in der Draufsicht auf das Gehäuse in Fig. 2 in einer geöffneten Position mit einem Öffnungswinkel von etwa 180° gezeigt ist, wobei der Winkel jeweils zwischen der flächigen Erstreckung des Gehäusedeckels 4 und des Gehäusebodens 2 gemessen ist. Die Breite der in Fig. 1 in Draufsicht gezeigten Gehäuseseitenwand 3 beträgt 249 mm, während die Länge der Gehäuseseitenwand 3 385 mm beträgt. Die Höhe der Gehäuseseitenwand 3, einschließlich des Gehäusebodens 2, beträgt 19 mm. Jeder Innenraum 6 weist eine Breite von 85 mm bei einer Länge von 155 mm und einer Tief von 12,7 mm auf.

Der Gehäuseboden 2, die Gehäuseseitenwände 3, der Gehäusedeckel 4 und die Gehäusezwischenelemente 5 sind aus einem elektrisch leitfähige Partikel umfassenden Polymer ausgestaltet, wobei vorliegend der unter dem Markennamen ECCOSORB LS vertriebene Polyurethanschaum verwendet wird, welcher mit einem Latex imprägniert ist, der Rußteilchen enthält. Derart dient der Latex nach dem Trocknen der Dispersion als Bindemittel zur Fixierung des Rußes, so dass im Ergebnis, wie nachfolgend weiter ausgeführt ist, eine Dämpfung elektromagnetischer Wellen bewirkt wird. Konkret wird ECCOSORB LS in der Spezifikation LS-26 verwendet, welches durch eine Dämpfung von 16 dB/cm und einen relativen Wellenwiderstand Z/Z₀ von 0,18 bei einer Frequenz von 3 GHz bzw. eine Dämpfung von 34 dB/cm und einen relativen Wellenwiderstand Z/Z₀ von 0,31 bei einer Frequenz von 10 GHz gekennzeichnet ist. ECCOSORB LS in der Spezifikation LS-26 weist eine Dicke von 0,25" bzw. 6,35 mm auf, wobei die Polyurethanschaumplatten typischerweise in Größen von 24" x 24" bzw. 61 cm x 61 cm zu erwerben sind.

Zur Herstellung des Gehäuses werden Lagen der Polyurethanschaumplatten maschinell oder manuell beispielsweise mittels eines scharfen Messers in die vorab genannten Maße zur Ausbildung des Gehäusebodens 2, der Gehäuseseitenwände 3, des Gehäusedeckels 4 und der Gehäusezwischenelemente 5 geschnitten. Zweckmäßigerweise wird zunächst eine Bodenplatte 7 aus einem Kunststoff mit einer Dicke von 4 mm und einer Breite von 249 mm und Länge von 385 mm rechtwinklig mit einer Seitenplatte 8 aus einem Kunststoff mit einer Dicke von 4 mm, einer Breite von 30 mm und Länge von 385 mm unter Verwendung eines Polyethylen aufweisenden Schweißdrahtes mittels eines Schweißaufsatzes eines Heißluftföns oder dergleichen verschweißt. Die gemeinsame Außenkante der Bodenplatte 7 und der Seitenplatte 8 wird ohne Zugabe von Schweißdraht verschweißt. Zur besseren Fixierung der Polyurethanschaumplatten wird sodann die Innenseite der Seitenplatte 8 mit einem doppelseitigen Klebeband, welches beispielsweise unter dem Markennamen 3M 9527, Breite 19 mm, vertrieben wird, beklebt.

Der entsprechend auf Maß geschnittene Gehäuseboden 2 wird rechtsbündig auf die Bodenplatte 7 als erste Lage geklebt. Zwei weitere Lagen der Polyurethanschaumplatten werden auf den Gehäuseboden 2 zur Ausbildung der jeweiligen Gehäuseseitenwände 3 mit einem dem Fachmann bekannten Klebstoff geklebt. In den Innenräumen 6 sowie an dem Gehäusedeckel 4 dem Innenraum 6 zugewandt sind mehrere Telefonabstandselemente 9 an dem Gehäuseboden 2, den Gehäuseseitenwänden 3, dem Gehäusedeckels 4 und den Gehäusezwischenelemente 5 vorgesehen. Die an den Gehäuseseitenwänden 3 und an Gehäusezwischenelemente 5 vorgesehenen Telefonabstandselemente 9 sind als eckige Klebefüße ausgestaltet, die unter dem Markennamen 3M Zb 19 vertrieben werden, während die an dem Gehäusedeckel 4 und an dem Gehäuseboden 2 vorgesehenen Telefonabstandselemente 9 als runde Klebefüße ausgestaltet sind, die unter dem Markennamen 3M Sj5744 vertrieben werden.

Auf der obersten Lage des die Gehäuseseitenwände 3 und die Gehäusezwischenelemente 5 ausbildenden Polyurethanschaumplatten sind dem Gehäusedeckel 4 zugewandt Deckelabstandelemente 10 vorgesehen, welche vorliegend auch als runde Klebefüße ausgestaltet sind, die unter dem Markennamen 3M Sj5744 vertrieben werden. Derart bedeckt der Gehäusedeckel 4 in seiner nicht gezeigten geschlossenen Position die Innenräume 6 und liegt auf den Deckelabstandelementen 10 auf, wobei aufgrund der Deckelabstandelemente 10 ein Luftspalt zwischen den Gehäuseseitenwänden 3 und dem Gehäusedeckel 4 ausgebildet ist.

Der Gehäusedeckel 4 wird auf eine Deckelplatte 11 aus einem Kunststoff mit einer Dicke von 2 mm, einer Breite von 245 mm und Länge von 385 mm aufgeklebt. Der Gehäusedeckel 4 und die Deckelplatte 11 werden mittels eines sich über die gesamte Länge erstreckenden Scharnierbandes, welches beispielsweise unter dem Markennamen Kavan 0382 vertrieben wird, nicht gezeigt, an der Seitenwand 8 verschwenkbar befestigt, um derart ein buchartiges Gehäuse zur Aufnahme eines Mobiltelefons 12 auszugestalten. In der geschlossenen Position liegt der Gehäusedeckel 4 deckungsgleich auf dem Gehäuseboden 2. In die Gehäuseseitenwände 3 können nicht gezeigte Kabeldurchführungen zum elektrischen Verbinden der Mobiltelefone 12 eingearbeitet sein, beispielsweise um ein USB Kabel von außerhalb des Gehäuses in das Gehäuse hinein zu führen.

In jedem der vier Innenräume 6 ist ein Mobiltelefon 12 eingesetzt, welches vorliegend das unter dem Markennamen Samsung Galaxy S5 angebotene Mobiltelefon 12 ist. Jedes Mobiltelefon 12 liegt, bei geschlossenem Gehäusedeckel 4, an allen seinen Seiten jeweils berührend an einem der Telefonfonabstandselemente 9 an und ist derart lagefest in dem jeweiligen Innenraum 6 fixiert. Entsprechend ist zwischen jedem Mobiltelefon 12 und dem Gehäusedeckel 4, dem Gehäuseboden 2, den jeweiligen Gehäuseseitenwänden 4 und Gehäusezwischenelementen 5 jeweils ein Luftspalt 13 ausgebildet.

Aufgrund der vorliegend gewählten Dimensionierung und Materialbeschaffenheit des Gehäuses wird ein Mobilfunksignal des Mobiltelefons 12 auf der dem Innenraum 6 abgewandten Seite der Gehäusewand 1, also außerhalb des Gehäuses, gegenüber einer ungehinderten Ausbreitung um 13 dB gedämpft. Das Mobilfunksignal umfasst die von dem Mobiltelefon 12 erzeugte und/oder empfangene elektromagnetische Strahlung, beispielsweise nach dem Mobilfunkstandard GSM900, GSM1800 oder UMTS2100. Die Messung erfolgt dabei bevorzugt in einem Abstand von 10 cm, 50 cm oder einem Meter Abstand von dem Mobiltelefon 12 mittels dem Fachmann bekannter Verfahren und Methoden zur Bestimmung der von einem Mobiltelefon 12 erzeugten und/oder empfangenen elektromagnetischen Strahlung.

In Abhängigkeit der Dimensionierung des Gehäuses und der Materialbeschaffenheit lassen sich auch andere Dämpfungen erreichen, so beispielsweise im Bereich von ≥ 3 dB und ≤ 15 dB. Die Dämpfung lässt sich durch die Dicke des Gehäusedeckels 4, des Gehäusebodens 2, den Gehäuseseitenwänden 4 und Gehäusezwischenelementen 5 oder durch Auswahl einer anderen Spezifikation der vorliegend für die Gehäusewand 1 verwendeten Polyurethanschaums ECCOSORB LS, so beispielsweise die Spezifikation LS-14, LS-18, LS-20 oder LS-30, beeinflussen. Darüber hinaus lässt sich die Dämpfung auch durch die Größe des Luftspaltes zwischen dem Gehäusedeckel 4 und den Gehäuseseitenwänden 3 beeinflussen. Neben einem elektrisch leitfähige Partikel umfassenden Polymer als Gehäusewand 1 mit Kohlenstoffpartikeln lassen sich Polymere mit Metallpartikeln und/oder Nanopartikeln verwenden.

**Bezugszeichenliste**

| | |
|---|---|
| Gehäusewand | 1 |
| Gehäuseboden | 2 |
| Gehäuseseitenwand | 3 |
| Gehäusedeckel | 4 |
| Gehäusezwischenelement | 5 |
| Innenraum | 6 |
| Bodenplatte | 7 |
| Seitenplatte | 8 |
| Telefonabstandselement | 9 |
| Deckelabstandselement | 10 |
| Deckelplatte | 11 |
| Mobiltelefon | 12 |
| Luftspalt | 13 |

## Patentansprüche

1. Gehäuse zum Erhalten einer gleichbleibenden Dämpfung der Mobilfunksignale einer Mehrzahl Mobiltelefone (12), mit
der Mehrzahl Mobiltelefone (12),
einer Gehäusewand (1) umfassend ein elektrisch leitfähige Partikel umfassendes Polymer,
eine Mehrzahl Gehäusezwischenelemente (5) aus dem elektrisch leitfähige Partikel umfassenden Polymer, und
einer Mehrzahl an der Gehäusewand (1) angeordneten Telefonabstandselementen (9), wobei
in dem Gehäuse eine Mehrzahl von der Gehäusewand (1) sowie den Gehäusezwischenelementen (5) ausgebildeten und umgebenden Innenräume (6) vorgesehen sind, in denen die Mobiltelefone (12) eingesetzt sind,
die Mehrzahl Telefonabstandselemente (9) zwischen den Mobiltelefonen (12) und der Gehäusewand (1) zum Ausbilden eines Luftspalts (13) angeordnet sind,
die Gehäusewand (1) die Mobilfunksignale der Mobiltelefone (12) auf der dem Innenraum (6) abgewandten Seite der Gehäusewand (1) gegenüber einer ungehinderten Ausbreitung um ≥ 3 dB und ≤ 15 dB dämpft, und
die Telefonabstandselemente (9) jeweils zwischen allen Gehäuseseitenwänden (3), dem Gehäuseboden (2) und, bei mit einem Gehäusedeckel (4) bedecktem Innenraum (6), dem Gehäusedeckel (4) und den Mobiltelefonen (12) angeordnet sind, einen jeweiligen Luftspalt ausbilden (13) und die Mobiltelefone (12) in dem Innenraum (6) fixieren.

2. Gehäuse nach dem vorhergehenden Anspruch, wobei die Gehäusewand (1) die Mobilfunksignale um ≥ 7 dB und ≤ 13 dB dämpft.

3. Gehäuse nach einem der vorhergehenden Ansprüche, wobei die Gehäusewand (1) einen Gehäuseboden (2) und vier Gehäuseseitenwände (3) aufweist und der durch den Gehäuseboden (2) und vier Gehäuseseitenwände (3) ausgebildete Innenraum (6) eine quaderartige Form aufweist.

4. Gehäuse nach dem vorhergehenden Anspruch, wobei die Gehäusewand (1) einen Gehäusedeckel (4) zum Bedecken des Innenraums (6) aufweist und der Gehäusedeckel (4) verschwenkbar an einer Gehäuseseitenwand (3) gehalten ist.

5. Gehäuse nach dem vorhergehenden Anspruch 4, mit einem Deckelabstandelement (10) welches, bei mit dem Gehäusedeckel (4) bedecktem Innenraum (6), zwischen einer Gehäuseseitenwand (3) und dem Gehäusedeckel (4) angeordnet ist und einen Luftspalt zwischen der Gehäuseseitenwand (3) und dem Gehäusedeckel (4) ausbildet.

6. Gehäuse nach einem der vorhergehenden Ansprüche, wobei die Gehäusewand (1) eine Imprägnierung einer Ruß-Dispersion aufweist, die Gehäusewand (1) eine Kohlenstoffteilchen umfassende Schicht mit einem spezifischen Widerstand von ≥ 10⁻³ Ohm cm bis ≤ 10⁸ Ohm cm aufweist und/oder die Gehäusewand (1) aus einem Polyurethanschaum ausgestaltet ist, der einen relativen Wellenwiderstand von ≥ 0,13 und ≤ 0,83, gemessen bei einer Frequenz von 3 GHz, aufweist.

7. Verfahren zum Erzielen einer gleichbleibenden Dämpfung der Mobilfunksignals der Mobiltelefone (12), mit den Schritten:
Bereitstellen eines Gehäuses nach einem der Ansprüche 1 bis 6,
Einsetzen der Mobiltelefone (12) in den Innenraum (6), und
Bedecken des Innenraums (6) mit dem Gehäusedeckel (4).

8. Verfahren nach dem vorhergehenden Anspruch, mit dem Schritt:
Messen unterschiedlicher Mobilfunknetze mittels der Mehrzahl Mobiltelefone (12).

## Claims

1. A housing designed to invariantly attenuate mobile radio signals of a plurality of mobile telephones (12),
having the plurality of mobile telephones (12),
having a housing wall (1), comprising
a polymer comprising electrically conductive particles,
a plurality of housing intermediate elements (5) made from the polymer comprising electrically conductive particles, and
a plurality of telephone spacing elements (9) arranged at the housing wall (1),
wherein
in the housing a plurality of inner chambers (6) into which the mobile telephones (12) can be inserted are provided and enclosed by the housing wall (1) and the housing intermediate elements (5),
the plurality of telephone spacing elements (9) are arranged between the mobile telephones (12) and the housing wall (1) in such a way that an air gap (13) is formed,
the housing wall (1) attenuates the mobile radio signals of the mobile telephones (12) by ≥ 3 dB and by ≤ 15 dB on the side of the housing wall (1) facing away from the inner chamber (6), as compared to an unobstructed propagation,
the telephone spacing elements (9) are arranged in such a way that an air gap (13) is formed, and that the mobile telephones (12) are fixed in the inner chamber (6), and
the telephone spacing elements (9) are arranged between the mobile telephones (12) and all housing side walls (3), between the mobile telephones (12) and a housing base (2), and, when the inner chamber (6) is covered with a housing cover (4), between the mobile telephones (12) and the housing cover (4).

2. Housing according to the preceding claim, wherein the housing wall (1) is designed to attenuate the mobile radio signal by ≥ 7 dB and ≤ 13 dB.

3. Housing according to any of the preceding claims, wherein the housing wall (1) comprises the housing base (2) and four housing side walls (3) and the inner chamber (6) formed by the housing base (2) and the four housing side walls (3) has a cuboid shape.

4. Housing according to the preceding claim 3, wherein the housing wall (1) comprises the housing cover (4) for covering the inner chamber (6) and the housing cover (4) is pivotably held on one of the housing side walls (3).

5. Housing according to the preceding claim 4, having a cover spacing element (10) which is intended to form an air gap between the housing side wall (3) and the housing cover (4) when the inner chamber (6) is covered with the housing cover (4).

6. Housing according to any of the preceding claims, wherein the housing wall (1) is impregnated with a soot dispersion, the housing wall (1) comprises a layer comprising carbon particles and whereas the layer has a specific resistance of ≥ 10⁻³ ohm cm to ≤ 10⁸ ohm cm, and/or the housing wall (1) is made from a polyurethane foam which has a relative wave impedance of ≥ 0.13 and ≤ 0.83, measured at a frequency of 3 GHz.

7. Method for attenuating mobile radio signals of mobile telephones (12) in an invariant manner, comprising the steps of:
Providing a housing according to any of the claims 1 to 6,
Inserting the mobile telephones (12) into the inner chamber (6), and
Covering the inner chamber (6) with the housing cover (4).

8. Method according to the preceding claim,
comprising the step of:
Measuring different mobile networks with the plurality of the mobile telephones (12).

## Revendications

1. Boîtier pour l'obtention d'une atténuation stable des signaux radio mobiles d'une multiplicité de téléphones mobiles (12), avec
la multiplicité de téléphones mobiles (12),
une paroi de boîtier (1) comprenant un polymère comprenant des particules électriquement conductrices,
une multiplicité d'éléments intermédiaires de boîtier (5) à base du polymère comprenant des particules électriquement conductrices, et
une multiplicité d'éléments d'espacement de téléphones (9) disposés sur la paroi de boîtier (1), où
une multiplicité d'espaces intérieurs (6), formés et entourés par la paroi de boîtier (1) ainsi que par les éléments intermédiaires de boîtier (5), dans lesquels sont implantés les téléphones mobiles (12), est prévue dans le boîtier,
la multiplicité des éléments d'espacement de téléphones (9) est disposée entre les téléphones mobiles (12) et la paroi de boîtier (1) pour former une fente (13),
la paroi de boîtier (1) atténue les signaux radio mobiles des téléphones mobiles (12) sur le côté de la paroi de boîtier (1) opposé à l'espace intérieur (6) par rapport à une propagation non atténuée de ≥ 3 dB et ≤ 15 dB, et
les éléments d'espacement de téléphones (9) sont respectivement disposés entre toutes les parois latérales de boîtier (3), le socle du boîtier (2) et, dans le cas d'un espace intérieur (6) recouvert avec un couvercle de boîtier (4), entre le couvercle de boitier (4) et les téléphones mobiles (12), forment une fente (13) à chaque fois et fixent les téléphones mobiles (12) dans l'espace intérieur (6).

2. Boîtier selon la revendication précédente, dans lequel la paroi de boîtier (1) atténue les signaux radio mobiles de ≥ 7 dB et ≤ 13 dB.

3. Boîtier selon l'une des revendications précédentes, dans lequel la paroi de boîtier (1) présente un socle de boîtier (2) et quatre parois latérales de boîtier (3), et l'espace intérieur (6) formé par le socle de boîtier (2) et quatre parois latérales de boîtier (3) présente une forme rectangulaire.

4. Boîtier selon la revendication précédente, dans lequel la paroi de boîtier (1) présente un couvercle de boîtier (4) pour recouvrir l'espace intérieur (6) et le couvercle de boîtier (4) est maintenu en pouvant pivoter sur une paroi latérale de boîtier (3).

5. Boîtier selon la revendication précédente 4, avec un élément d'espacement de couvercle (10), lequel est disposé près de l'espace intérieur (6) recouvert avec le couvercle de boîtier (4), entre une paroi latérale de boîtier (3) et le couvercle de boîtier (4) et forme une fente entre la paroi latérale de boîtier (3) et le couvercle de boîtier (4).

6. Boîtier selon l'une des revendications précédentes, dans lequel la paroi de boîtier (1) présente une imprégnation avec une dispersion de suie, la paroi de boîtier (1) présente une couche comprenant des particules de carbone avec une résistance spécifique ≥ 10⁻³ Ohm cm à ≤ 10⁸ Ohm cm, et/ou la paroi de boitier (1) est conçue à base d'une mousse de polyuréthane qui présente une résistance relative vis-à-vis des ondes ≥ 0,13 et ≤ 0,83, mesurée à une fréquence de 3 GHz.

7. Procédé d'obtention d'une atténuation continue des signaux radio mobiles des téléphones mobiles (12), avec les étapes :
de mise au point d'un boîtier selon l'une des revendications 1 à 6,
d'implantation des téléphones mobiles (12) dans l'espace intérieur (6), et
de couverture de l'espace intérieur (6) avec le couvercle de boîtier (4).

8. Procédé selon la revendication précédente, avec l'étape :
de mesure de réseaux radio mobiles divers au moyen d'une multiplicité de téléphones mobiles (12).
